# EUROPÄISCHE PATENTSCHRIFT

(11) **EP 1 369 994 B1**
(45) Veröffentlichungstag und Bekanntmachung des Hinweises auf die Patenterteilung: **11.09.2013**
(21) Anmeldenummer: 03006909.0
(22) Anmeldetag: 26.03.2003
(51) Int. Cl.: H03G 5/22

(54) **Verfahren zur zugehörrichtigen Basspegelanhebung und zugeordnetes Wiedergabesystem**
Method for boosting low frequencies adapted to an auditory system and corresponding reproduction system
Méthode d'augmentation de niveau des basses fréquences conforme a l'ouie et système de reproduction correspondant

(30) Priorität: 06.06.2002 DE 10225145
(43) Veröffentlichungstag der Anmeldung: 10.12.2003
(73) Patentinhaber: ROBERT BOSCH GMBH, 70442 Stuttgart (DE)
(72) Erfinder: Dietrich, Walter, 71384 Weinstadt (DE); Krieger, Eberhard, 71384 Weinstadt (DE); Wieduwilt, Ulrich, 73529 Schwaebisch Gmuend (DE); Montag, Christoph, 31134 Hildesheim (DE); Sahrhage, Joerg, 31139 Hildesheim (DE); Zeller, Johann, 71679 Asperg (DE)

(56) Entgegenhaltungen:
- EP-A- 0 451 620
- EP-A2- 1 372 262
- DE-A- 10 027 618
- DE-A1- 10 017 277
- FR-A- 2 478 409
- US-A- 5 995 817

## Beschreibung

### Technisches Gebiet

Die vorliegende Erfindung betrifft ein Verfahren gemäß dem Oberbegriff des Anspruchs 1 (vgl. Druckschrift DE 100 17 277 A1).

Die vorliegende Erfindung betrifft des weiteren ein Wiedergabesystem gemäß dem Oberbegriff des Anspruchs 5.

### Stand der Technik

Die Erfindung geht von aus der Praxis bekannten Autoradiogeräten aus, die auf der sogenannten "2IC-Technologie" basieren, bei der das Audio-Wiedergabegerät und insbesondere dessen Tuner mit einer insbesondere digitalen Empfängereinheit, beispielsweise mit einem "digital receiver" (sogenannter "digiceiver"), versehen ist. Dies bedeutet mit anderen Worten, dass bereits im Empfangsteil des Tuners das hochfrequente Signal der Z[wischen]F[requenz]-Stufe bei beispielsweise 10,7 Megahertz in Bits und Bytes umgesetzt wird und daran anschließend bis zu den Endstufen konsequent auf digitaler Ebene weiterverarbeitet wird.

Bei derartigen Autoradiogeräten sind beispielsweise zwei oder drei frei programmierbare Audiofilter in den Signalpfad integriert. Diese digitalen parametrischen Equalizer (= DPE) stehen dem Benutzer zur Verfügung, um Unzulänglichkeiten der Akustik im Fahrzeuginnenraum zu kompensieren. Der Benutzer kann jedes Filter in bezug auf bestimmte Filterparameter, wie etwa in bezug auf die Dämpfung, in bezug auf die Güte, das heißt die Filterbreite, in bezug auf die Mittenfrequenz und/oder in bezug auf die Verstärkung variieren, um Überhöhungen und sogenannte Löcher im akustischen Frequenzgang des Fahrzeuginnenraums auszugleichen.

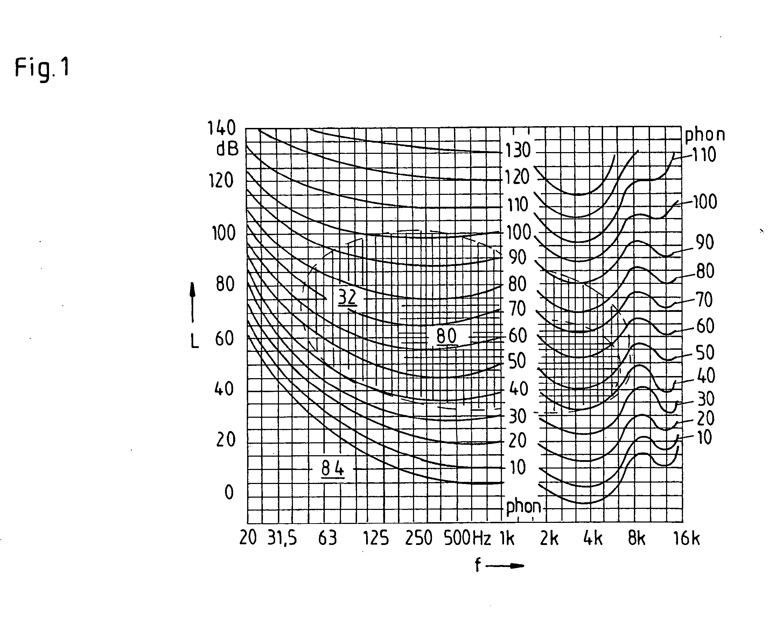

Im Zusammenhang mit dem akustischen Frequenzgang oder allgemeiner mit dem Lautstärkeempfinden des menschlichen Gehörs ist zu bedenken, dass dieses Lautstärkeempfinden über den hörbaren Frequenzbereich unterschiedlich ausgeprägt ist. Dies bedeutet mit anderen Worten, daß die Empfindlichkeit des menschlichen Gehörs nicht konstant über der Frequenz ist, sondern zu hohen Frequenzen und in noch stärkerem Maße zu niedrigen Frequenzen hin abnimmt. Dieser Effekt tritt mit sinkendem Schalldruckpegel verstärkt auf und wird, wie in Figur 1 dargestellt, in der Literatur durch Kurven gleicher Lautstärke (= sogenannte Isophonen) als Funktion des Schalldruckpegels L (in dB = Dezibel) über der Frequenz f (in Hz = Hertz) beschrieben (vgl. auch l[nternational]S[tandardization]O[rganization] 226).

Um zum Beispiel bei einer Audiofrequenz von einhundert Hertz den gleichen Lautstärkeeindruck wie bei einer Frequenz von einem Kilohertz zu erzielen, ist ein wesentlich höherer Schalldruck erforderlich. Dieser Zusammenhang wird durch die Darstellung der vorerwähnten Linien gleicher Lautheit in einem Schalldruck/Frequenz-Diagramm dargestellt (vgl. Figur 1, in der der Sprachbereich durch das Bezugszeichen 80, der Musikbereich durch das Bezugszeichen 82 und der Bereich der Hörschwelle durch das Bezugszeichen 84 kenntlich gemacht sind).

Zum Kompensieren dieses Effekts verfügen Systeme zum Wiedergeben von Audiosignalen häufig über eine Vorrichtung zum selektiven Anheben des Pegels der Bässe bei niedriger Wiedergabelautstärke; bei manchen Systemen werden die Höhen ebenfalls ein wenig angehoben. Diese als "gehörrichtige Lautstärkekorrektur" oder "Loudness Control" bezeichnete Vorrichtung soll die vom Zuhörer wahrgenommene Lautheit des Audiosignals unabhängig von der Wiedergabelautstärke über das ganze Hörfrequenzspektrum konstant halten, das heißt ein spektral ausgewogenes Klangbild gewährleisten.

Zum Einsatz kommen hierbei in der Regel Rekursivfilter erster Ordnung oder zweiter Ordnung, die entweder als Resonanzfilter oder als Shelvingfilter konfiguriert sind. Während Resonanzfilter durch die Parameter Anhebung G, Güte Q und Mittenfrequenz f₀ charakterisiert werden und dazu geeignet sind, ein beliebiges schmales Frequenzband anzuheben, zeichnen sich Shelvingfilter dadurch aus, daß mit ihrer Hilfe der gesamte Frequenzbereich unterhalb bzw. oberhalb einer gewissen Grenzfrequenz f_{c} angehoben wird, wobei die Filtersteilheit allein durch die Filterordnung festgelegt ist.

Ein Problem bei der Realisierung einer gehörrichtigen Lautstärkekorrektur besteht oftmals darin, daß die eingesetzten Lautsprechersysteme nur sehr unzureichend in der Lage sind, die notwendigerweise anzuhebenden tiefen Frequenzen wiederzugeben. Die zu sehr tiefen Frequenzen stark zunehmende Pegelanhebung bleibt unter diesen Umständen einerseits akustisch wirkungslos und führt andererseits zu unnötiger Übersteuerung der Leistungsverstärkerstufen und der Lautsprecher, die sich zumindest in einem erhöhten Klirrfaktor äußert.

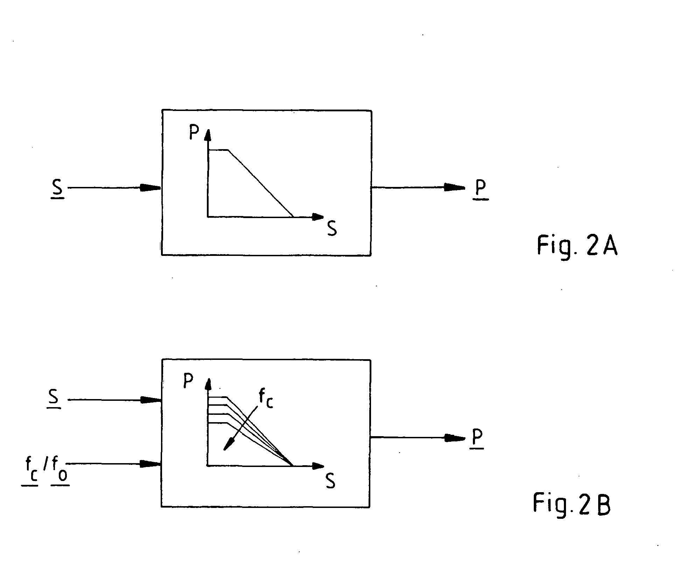

Aus diesem Grunde bieten einige Audiowiedergabesysteme bereits die Möglichkeit, die Filtergrenzfrequenz f_{c} bzw. die Filtermittenfrequenz f₀ so weit nach oben zu verschieben, bis sich ein hörbarer Effekt einstellt. Allerdings wird bei allen bislang bekannten Wiedergabesystemen die vorbeschriebene selektive Pegelanhebung gemäß Figur 2A unabhängig von der gewählten Filtergrenzfrequenz f_{c} bzw. unabhängig von der gewählten Filtermittenfrequenz f₀ nach einer fest vorgegebenen Funktion allein durch die vom Benutzer am Wiedergabegerät eingestellte Lautstärke S gesteuert.

Eine derartige herkömmliche Vorgehensweise wird jedoch für den Fall einer angehobenen Grenzfrequenz f_{c} bzw. Mittenfrequenz f₀ des Baßanhebungsfilters den psychoakustischen Erkenntnissen nicht gerecht, denn in diesem Falle werden die tiefen Frequenzen übermäßig stark angehoben.

### Darstellung der Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, ein Verfahren der eingangs genannten Art sowie ein Wiedergabesystem der eingangs genannten Art so weiterzuentwickeln, daß eine übermäßige Anhebung des Baßpegels vermieden wird.

Diese Aufgabe wird gemäß der Lehre der vorliegenden Erfindung durch ein Verfahren mit den im Anspruch 1 genannten Merkmalen sowie durch ein Wiedergabesystem mit den im Anspruch 5 genannten Merkmalen gelöst. Vorteilhafte Ausgestaltungen und zweckmäßige Weiterbildungen der vorliegenden Erfindung sind in den jeweiligen Unteränsprüchen gekennzeichnet.

Mithin ist der Kern der vorliegenden Erfindung in einem Verfahren zur gehörrichtigen Frequenzgangkorrektur im Baßfrequenzbereich zu sehen, bei der infolge zusätzlicher geeigneter Berücksichtigung der eingestellten Filtergrenzfrequenz f_{c} bzw. der eingestellten Filtermittenfrequenz f₀ eine psychoakustisch sinnvolle Anhebung des Baßpegels P bei gleichzeitiger Minimierung von Systemübersteuerungen erzielt wird; mithin liegt eine gehörrichtige Baßpegelanhebung als Funktion der Filtereinsatzfrequenz vor.

Dies wird erfindungsgemäß erreicht durch ein Verfahren zum vorzugsweise automatischen Optimieren der gehörrichtigen Anhebung des Baßpegels P auf das Audiowiedergabesystem, bei dem der bzw. die Filterparameter der Baßanhebungsfiltereinheit so eingestellt wird bzw. werden, daß die Anhebung des Baßpegels P mit steigender Grenzfrequenz f_{c} bzw. mit steigender Mittenfrequenz f₀ der Baßanhebungsfiltereinheit derart reduziert wird, daß die Isophonen im verbleibenden wiedergebbaren Baßfrequenzbereich nicht überschritten werden.

Mit der vorliegenden Erfindung wird dem Benutzer also die schwierige Aufgabe der Anpassung der Baßanhebungsfiltereinheit(en) an die spezielle Akustik seines Fahrzeuginnenraums abgenommen.

Wenn das Einhalten eines funktionellen Zusammenhangs zwischen der Mittenfrequenz f₀ der Baßanhebungsfiltereinheit und dem gehörrichtigen Anheben des Baßpegels P nicht mit einem manuellen Einstellen, sondern mit einem automatischen Bestimmen dieser Mittenfrequenz f₀ einhergeht, so wird vor dem Einstellen des mindestens einen Filterparameters der Baßanhebungsfiltereinheit
- zunächst der akustische Frequenzgang des Fahrzeuginnenraums ermittelt,
- dann der mittlere Schalldruck ermittelt und
- dann eine Grenzfrequenz bestimmt, unterhalb derer der Schalldruck einen auf den mittleren Schalldruck bezogenen Schalldruckschwellwert unterschreitet.

Im Detail wird zunächst der Frequenzgang des vorliegenden Audiowiedergabesystems mithilfe geeigneter Vorkehrungen ermittelt. Im Anschluß wird der gemessene Frequenzgang hinsichtlich des Wirkungsgrads des Wiedergabesystems im tieffrequenten Bereich ausgewertet.

Aus dem gemessenen Frequenzgang kann zunächst der mittlere Schalldruck ermittelt werden. Im Anschluß daran wird der Frequenzpunkt im tieffrequenten Bereich ermittelt, unterhalb dessen der Schalldruck einen bestimmten, auf den mittleren Schalldruck bezogenen Grenzwert unterschreitet, zum Beispiel etwa drei Dezibel.

Ein Baßanhebungsfilter wird nun genau so eingestellt, daß die Isophonen im verbleibenden wiedergebbaren Baßfrequenzbereich nicht überschritten werden; dies wird erreicht, indem die Anhebung des Baßpegels P mit steigender Grenzfrequenz f_{c} bzw. mit steigender Mittenfrequenz f₀ der Baßanhebungsfiltereinheit reduziert wird, so daß eine Pegelkennlinienschar in Abhängigkeit von der Filtergrenzfrequenz f_{c} (--> Shelvingfilter) bzw. von der Filtermittenfrequenz f₀ (--> Resonanzfilter) entsteht.

Auf diese Weise wird einerseits sichergestellt, daß die Baßanhebung auch akustisch wirksam ist, andererseits wird das System nicht überlastet, denn der Frequenzgang des Baßanhebungsfilters bleibt im Falle der Ausgestaltung als mindestens ein Shelvingfilter unterhalb der Grenzfrequenz f_{c} konstant bzw. fällt im Falle der Ausgestaltung als mindestens ein Resonanzfilter unterhalb der Mittenfrequenz f₀ wieder ab.

Des weiteren wird ein Wiedergabesystem der eingangs genannten Art vorgeschlagen, das zur gehörrichtigen Anhebung des Baßpegels P, das heißt zum vorzugsweise automatischen Einstellen der mindestens einen Baßanhebungsfiltereinheit erfindungsgemäß einen Rauschgenerator umfaßt, über den sich dem der Baßanhebungsfiltereinheit zugeordneten Equalizer ein Rauschsignal zuführen läßt.

Außerdem weist der Steuerungsprozessor Mittel auf, über die die Filterparameter so einstellbar sind, daß der Equalizer eine Bandpaßcharakteristik mit schmaler Bandbreite aufweist, wobei die Mittenfrequenz über dem Audiospektrum variierbar ist.

Zum Erfassen des von der Lautsprechereinrichtung in den Fahrzeuginnenraum abgestrahlten Signals und zum Bestimmen des Frequenzgangs ist mindestens ein Mikrophon mit Auswertemitteln vorgesehen.

Schließlich weist der Steuerungsprozessor noch Mittel auf, über die die Filterparameter unter Berücksichtigung des gemessenen Frequenzgangs einstellbar sind.

Es ist erkannt worden, daß die einzumessenden Equalizer aufgrund ihrer Programmierbarkeit zunächst zur Bestimmung des akustischen Frequenzgangs des Fahrzeuginnenraums verwendet werden können, bevor eine Grenzfrequenz bestimmt werden kann, unterhalb derer der Schalldruck einen auf den mittleren Schalldruck bezogenen Schalldruckschwellwert unterschreitet.

Des weiteren ist erfindungsgemäß erkannt worden, daß für die Bestimmung der gehörrichtigen Anhebung des Baßpegels P neben der eingestellten Lautstärke S zusätzlich die Filtergrenz- bzw. -mittenfrequenz f_{c} bzw. f₀ des Baßanhebungs- oder Loudnessfilters in geeigneter Weise zu berücksichtigen ist. Wie Figur 2B entnehmbar ist, wird die Steigung der Verstärkungskennlinie des Baßanhebungsfilters mit ansteigender Filtergrenz- bzw. -mittenfrequenz f_{c} bzw. f₀ so reduziert, daß die Isophonen im verbleibenden wiedergebbaren Baßfrequenzbereich nicht überschritten werden und damit eine übermäßige Baßanhebung vermieden wird.

Der Zusammenhang zwischen der Filtermitten-/-grenzfrequenz sowie der eingestellten Lautstärke S als Eingangsgrößen und der resultierenden Baßanhebung als Ausgangsgröße erfolgt über eine mathematische Funktion und kann, abhängig von den jeweiligen Gegebenheiten, in erfindungswesentlicher Weise kontinuierlich oder in Stufen erfolgen. Im Ergebnis erfolgt also eine automatische Optimierung einer gehörrichtigen Baßpegelanhebung, indem die Filterparameter der Baßanhebungsfiltereinheit in Abhängigkeit von oder als Funktion der Grenzfrequenz f_{c} bzw. der Mittenfrequenz f₀ eingestellt werden.

Es besteht also ein funktioneller Zusammenhang zwischen der Grenz/Mittenfrequenz f_{c} bzw. f₀ des Loudness-Filters und der notwendigen Verstärkung sowie der notwendigen Güte, der für eine wirklich gehörrichtige Lautheitskorrektur sinnvoll ist. Das Einhalten dieses Zusammenhangs kann, muß jedoch nicht mit einem automatischen Ermitteln der Grenz/Mittenfrequenz f_{c} bzw. f_{c} verknüpft sein.

Dies bedeutet mit anderen Worten, daß der vorbeschriebene funktionelle Zusammenhang sowohl bei manuellem Verstellen der Grenz/Mittenfrequenz f_{c} bzw. f₀ als auch bei automatischem Einstellen der Grenz-/Mittenfrequenz f_{c} bzw. f₀ eingehalten werden sollte. Im letzteren Falle kann das Merkmal, daß die Anhebung des Baßpegels P mit steigender Grenzfrequenz f_{c} bzw. mit steigender Mittenfrequenz f₀ der Baßanhebungsfiltereinheit derart reduziert wird, daß die Isophonen im verbleibenden wiedergebbaren Baßfrequenzbereich nicht überschritten werden, in erfindungswesentlicher Weise mit dem Merkmal verknüpft werden, daß der bzw. die Filterparameter der Baßanhebungsfiltereinheit automatisch so eingestellt wird bzw. werden, daß die Mittenfrequenz der Baßanhebungsfiltereinheit gerade oberhalb der bestimmten Grenzfrequenz liegt.

Hierdurch wird in synergetischer Weise zum einen eine übermäßige Anhebung des Baßpegels P vermieden, zum anderen erfolgt jedoch gleichwohl eine automatische Optimierung der gehörrichtigen Baßpegelanhebung. Ferner ist erfindungsgemäß erkannt worden, daß die Optimierung der gehörrichtigen Anhebung des Baßpegels P mithilfe einer entsprechenden Zusatzsoftware vom ohnehin vorhandenen Steuerungsprozessor des Autoradiogeräts vorgenommen werden kann.

Im Ergebnis ist also im Rahmen der vorliegenden Erfindung kein zusätzliches Audiomodul mit digitalem Signalprozessor erforderlich, sondern lediglich eine Mikrophon-, Verstärkungs- und Gleichrichtungsschaltung, die an die im Steuerungsprozessor vorhandene A[nalog]/D[igital]-Wandlereinheit angekoppelt wird; hierdurch ist für die erfindungsgemäß vorgeschlagene Einstellung der Filterparameter in bezug auf die Baßpegelanhebung lediglich ein sehr geringer Mehraufwand an Hardware sowie an Software und mithin an Kosten erforderlich.

Grundsätzlich gibt es verschiedene Möglichkeiten für die Ermittlung des akustischen Frequenzgangs des Fahrzeuginnenraums im Rahmen des vorliegenden Verfahrens. Gemäß einer vorteilhaften Ausgestaltungsform wird die Lautsprechereinrichtung des Wiedergabesystems nacheinander von Bandpaß-Rauschsignalen mit unterschiedlichen Mittenfrequenzen angesteuert. Die jeweils in Form eines Bandpaß-Rauschsignals eingestellten Frequenzbänder decken das gesamte Audiospektrum ab.

Der zu ermittelnde Frequenzgang wird nun in Form von Frequenzmeßpunkten für die einzelnen Frequenzbänder ermittelt. Als Frequenzmeßpunkt für ein bestimmtes Frequenzband kann einfach der Schallpegel des Signals bestimmt werden, das in diesem Fall von der Lautsprechereinrichtung in den Fahrzeuginnenraum abgestrahlt wird.

Im Hinblick auf eine Minimierung des Hardware-Aufwands sowie des Software-Aufwands erweist es sich als vorteilhaft, die Bandpaß-Rauschsignale zum Ermitteln des akustischen Frequenzgangs des Fahrzeuginnenraums mithilfe des einzustellenden Equalizers selbst zu erzeugen. Da dieser sowohl in seiner Mittenfrequenz als auch in seiner Güte frei programmierbar ist, können die Filterparameter so eingestellt werden, daß sich für den Equalizer eine Bandpaßcharakteristik mit schmaler Bandbreite bei vorgegebener Mittenfrequenz ergibt.

Der Equalizer erzeugt dann aus einem ihm zugeführten Rauschsignal das gewünschte Bandpaß-Rauschsignal bzw. eine Abfolge von Bandpaß-Rauschsignalen, die das gesamte Audiospektrum abdecken.

Werden die Filterparameter von mehreren digitalen Equalizern automatisch eingestellt, so ist es von Vorteil, die Filterparameter der einzelnen Equalizer nacheinander zu bestimmen, indem jeweils vor dem Bestimmen der Filterparameter eines Equalizers der bzw. die vorher eingestellten Equalizer auf den gemessenen Frequenzgang angewendet werden.

Die vorliegende Erfindung betrifft schließlich die Verwendung des Verfahrens gemäß der vorstehend dargelegten Art und/oder des Wiedergabesystems gemäß der vorstehend dargelegten Art für Audiosignale in mindestens einem Fortbewegungsmittel, insbesondere im Innenraum mindestens eines Kraftfahrzeugs.

### Kurze Beschreibung der Zeichnungen

Wie bereits voranstehend ausführlich erörtert, gibt es verschiedene Möglichkeiten, die Lehre der vorliegenden Erfindung in vorteilhafter Weise auszugestalten und weiterzubilden. Hierzu wird einerseits auf die den Ansprüchen 1 und 7 nachgeordneten Ansprüche verwiesen, andererseits werden weitere Ausgestaltungen, Merkmale und Vorteile der vorliegenden Erfindung nachstehend anhand des durch die Figuren 2B bis 4 veranschaulichten Ausführungsbeispiels näher erläutert.

Es zeigt:
- Fig. 1: ein gemäß l[nternational]S[tandardization]O[rganization] normiertes Diagramm für Kurven gleicher Lautstärke (= sogenannte Isophonen), die als Funktion des Schallpegeldrucks über der Frequenz aufgetragen sind;
- Fig. 2A: ein schematisches Diagramm einer Pegelkennlinie (= Baßanhebung P, aufgetragen über der Lautstärke S) einer konventionellen gehörrichtigen Baßpegelkorrektur gemäß dem Stand der Technik;
- Fig. 2B: ein schematisches Diagramm einer in Abhängigkeit von der Filtergrenzfrequenz bzw. von der Filtermittenfrequenz gebildeten Pegelkennlinienschar (= Baßanhebung P, aufgetragen über der Lautstärke S) einer gehörrichtigen Baßpegelkorrektur nach dem Verfahren gemäß der vorliegenden Erfindung;
- Fig. 3: ein schematisches Blockschaltbild (= Ablaufdiagramm) eines Ausführungsbeispiels für ein Verfahren gemäß der vorliegenden Erfindung; und
- Fig. 4: eine schematische Prinzipdarstellung (= Blockdiagramm) eines Ausführungsbeispiels für ein Wiedergabesystem gemäß der vorliegenden Erfindung, das zum Durchführen des Verfahrens gemäß Fig. 3 vorgesehen ist.

### Bester Weg zur Ausführung der Erfindung

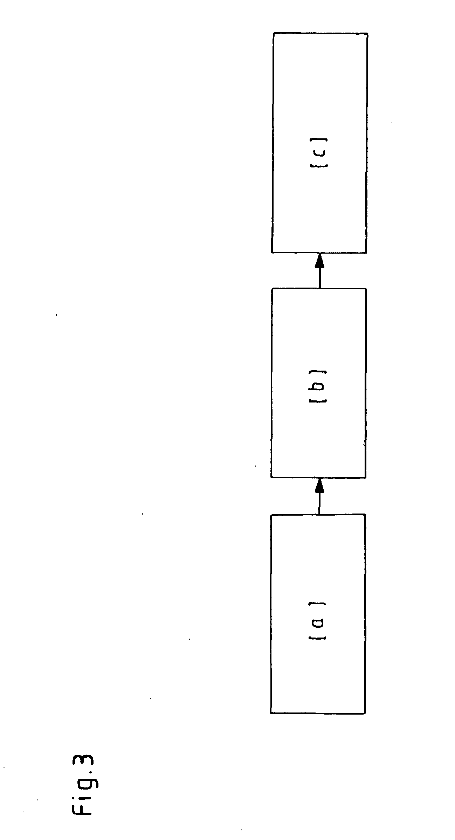

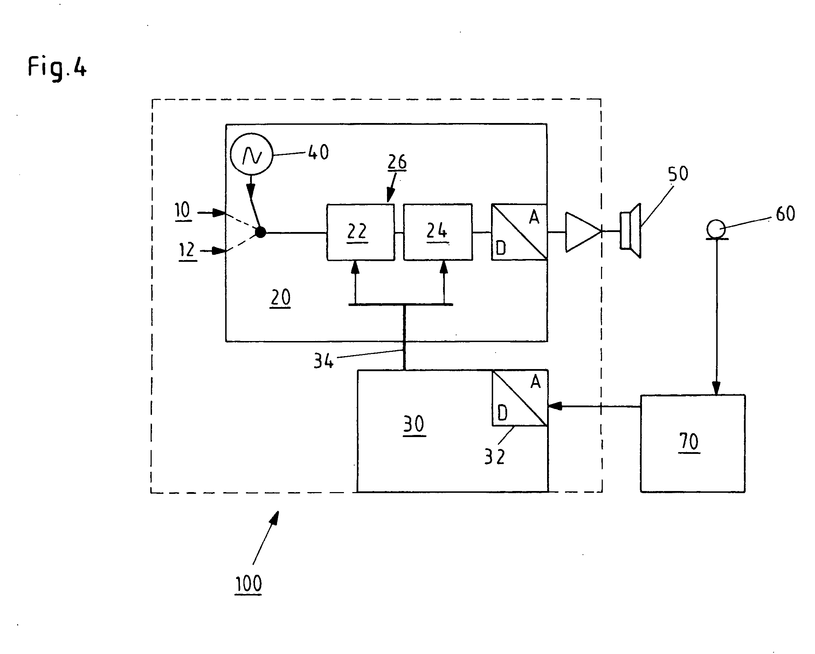

In Figur 3 ist das Funktionsprinzip eines anhand Figur 4 veranschaulichten Wiedergabesystems 100 gemäß der vorliegenden Erfindung skizziert.

Das in Figur 4 dargestellte Audiowiedergabesystem 100 dient der Wiedergabe von Audiosignalen in einem Fahrzeuginnenraum, wobei die Audiosignale von unterschiedlichen Audioquellen 10, 12, wie zum Beispiel von einer C[ompact]D[isc], von einem Radio oder von dergleichen, generiert werden können.

Das Wiedergabesystem 100 weist eine Lautsprechereinrichtung 50 und einen im Signalpfad zwischen den Audioquellen 10, 12 und der Lautsprechereinrichtung 50 angeordneten Audioprozessor 20 mit zwei frei einstellbaren digitalen Equalizern 22, 24 auf, über die die Signale der unterschiedlichen Audioquellen 10, 12 der Lautsprechereinrichtung 50 zugeführt werden; selbstverständlich können hier auch mehr als zwei Equalizer 22, 24 vorgesehen sein.

Zum Einstellen der Filterparameter, insbesondere zum Einstellen der Mittenfrequenz f₀, sendet ein Steuerungsprozessor 30 über einen Steuerungsbus 34 geeignete Filterparameter an den Audioprozessor 20.

Zum Bestimmen bzw. zum Messen des Frequenzgangs des vorliegenden Audiosystems im Fahrzeuginnenraum (= Verfahrensschritt [a] gemäß Figur 3) weist das Wiedergabesystem 100 ferner einen Rauschgenerator 40 auf, über den den Equalizern 22, 24 ein Rauschsignal zugeführt werden kann. Der Rauschgenerator 40 ist hier als Zusatzsoftware im Audioprozessor 20 implementiert und kann bei Bedarf über den Steuerungsprozessor 30 gestartet werden.

Alternativ hierzu kann das Rauschsignal auch von einer externen Rauschquelle als zusätzlicher Audioquelle erzeugt werden, zum Beispiel mithilfe einer entsprechenden C[ompact]D[isc] oder mithilfe eines in geeigneter Weise eingestellten Tuners.

Des weiteren weist der Steuerungsprozessor 30 Mittel auf, über die die Filterparameter so eingestellt werden können, daß die Equalizer 22, 24 eine Bandpaßcharakteristik mit schmaler Bandbreite, das heißt mit einer Güte der Größenordnung 8, aufweisen, wobei die Mittenfrequenz f₀ über dem Audiospektrum variierbar ist. Auf diese Weise kann die Lautsprechereinrichtung 50 mithilfe des Rauschgenerators 40 und über die Equalizer 22, 24 mit einem Bandpaß-Rauschsignal angesteuert werden.

Wenn das Einmessen der Equalizer 22, 24 beispielsweise durch Tastendruck gestartet worden ist, variiert der Steuerungsprozessor 30 die Filterparameter in definierter zeitlicher Abfolge so, daß die Mittenfrequenz f₀ des Bandpaßfilters zum Beispiel im Terzabstand von der höchsten einzustellenden Frequenz bis zur tiefsten einzustellenden Frequenz abnimmt.

Die Signale, die dann jeweils über die Lautsprechereinrichtung 50 in den Fahrzeuginnenraum abgestrahlt werden, werden mithilfe eines Mikrophons 60 erfaßt und mit geeigneten Auswertemitteln 70 zum Bestimmen des Frequenzgangs des Fahrzeuginnenraums ausgewertet.

Hierzu werden die vom Mikrophon 60 erfaßten Signale in einer Operationsverstärkerschaltung verstärkt, logarithmiert und gleichgerichtet, so daß am Ausgang dieser Schaltung eine Gleichspannung anliegt. Die Größe dieser Gleichspannung ist proportional zum Schallpegel bzw. zum Schalldruck im Fahrzeuginnenraum für das Frequenzband, das durch das jeweilige Bandpaß-Rauschsignal eingestellt ist. Durch das Durchstimmen der Equalizer 22, 24 wird der Schallpegel für das gesamte Audiospektrum detektiert.

Die den Schallpegel repräsentierende Gleichspannung wird von einem A[nalog]/D[igital]-Wandler 32 des Steuerungsprozessors 30 abgetastet, so daß dem Steuerungsprozessor 30 nach dem Durchstimmen aller zu messenden Frequenzen bzw. Frequenzbänder mit den entsprechenden Spannungswerten ein genaues Abbild des akustischen Frequenzgangs des Fahrzeuginnenraums vorliegt. Als Frequenzgang wird hier ausschließlich der Betragsfrequenzgang bzw. der Amplitudengang bezeichnet und nicht der Phasengang.

Im Steuerungsprozessor 30 wird nun in einem zweiten Verfahrensschritt [b] (vgl. Figur 3) eine untere Grenzfrequenz bestimmt, unterhalb derer der Schalldruck einen auf den mittleren Schalldruck bezogenen Schalldruckschwellwert unterschreitet.

In einem abschließenden Verfahrensschritt [c] (vgl. Figur 3) werden dann die Filterparameter, insbesondere die Anhebung G, die Güte Q und die Mittenfrequenz f₀ der Baßanhebungsfiltereinheit 26 automatisch so eingestellt, daß die Anhebung des Baßpegels P mit steigender Grenzfrequenz fc bzw. mit steigender Mittenfrequenz f₀ der Baßanhebungsfiltereinheit 26 derart reduziert wird (vgl. Figur 2B), daß die Isophonen (vgl. Figur 1) im verbleibenden wiedergebbaren Baßfrequenzbereich nicht überschritten werden.

Im Ergebnis erfolgt also eine automatische Optimierung einer gehörrichtigen Baßpegelanhebung, indem die Filterparameter der Baßanhebungsfiltereinheit 26 in Abhängigkeit von oder als Funktion der Grenzfrequenz f_{c} bzw. der Mittenfrequenz f₀ eingestellt werden. Es besteht also ein funktioneller Zusammenhang zwischen der Grenz-/Mittenfrequenz fc bzw. f₀ des Loudness-Filters 26 und der notwendigen Verstärkung sowie der notwendigen Güte, der für eine wirklich gehörrichtige Lautheitskorrektur sinnvoll ist.

Das Einhalten dieses Zusammenhangs kann, muß jedoch nicht mit einem automatischen Ermitteln der Grenz-/Mittenfrequenz f_{c} bzw. f₀ verknüpft sein; dies bedeutet mit anderen Worten, daß der vorbeschriebene funktionelle Zusammenhang sowohl bei manuellem Verstellen der Grenz/Mittenfrequenz fc bzw. f₀ der Baßanhebungsfiltereinheit 26 als auch bei automatischem Einstellen der Grenz-/Mittenfrequenz f_{c} bzw. f₀ der Baßanhebungsfiltereinheit 26 eingehalten werden sollte.

In erfindungswesentlicher Weise kann das Merkmal, daß die Anhebung des Baßpegels P mit steigender Grenzfrequenz f_{c} (--> Shelvingfilter) bzw. mit steigender Mittenfrequenz f₀ (--> Resonanzfilter) derart reduziert wird, daß die Isophonen im verbleibenden wiedergebbaren Baßfrequenzbereich nicht überschritten werden, mit dem Merkmal verknüpft werden, daß der bzw. die Filterparameter der Baßanhebungsfiltereinheit 26 automatisch so eingestellt wird bzw. werden, daß die Mittenfrequenz f₀ der Baßanhebungsfiltereinheit 26 gerade oberhalb der bestimmten Grenzfrequenz liegt; hierdurch wird in synergetischer Weise zum einen eine übermäßige Anhebung des Baßpegels vermieden, zum anderen erfolgt jedoch gleichwohl eine automatische Optimierung der gehörrichtigen Baßpegelanhebung.

Der gesamte Zusatzaufwand gegenüber einem Autoradiogerät, dessen Equalizer nicht automatisch einstellbar sind, besteht in einer Zusatzhardware 40 bzw. in einer Zusatzsoftware zum Generieren eines Rauschsignals, in einer Zusatzsoftware im Steuerungsprozessor 30, die die Ablaufsteuerung des Einmeßvorgangs (= Verfahrensschritt [a]; vgl. Figur 3) sowie die Ermittlung der besten Filterparametereinstellung(en) übernimmt, und in einer Zusatzhardware 70 für die Verstärkung, Logarithmierung und Gleichrichtung der Signale des Mikrophons 60.

Zum Ermitteln der bestmöglichen Einstellung der Filterparameter können im Audioprozessor 20 auch normierte Equalizer-Musterkurven mit unterschiedlicher Güte abgespeichert sein.

Abschließend sei noch angemerkt, daß sich die vorbeschriebene automatische gehörrichtige Baßpegelanhebung als Funktion der Mittenfrequenz f₀ bzw. der Grenzfrequenz f_{c} des Loudness-Filters 26 bei einem Erzeugnis 100 mit einstellbarer Loudness-Filter-Grenz- bzw. Mittenfrequenz durch Vermessung der Loudnessfunktion problemlos nachweisen läßt (<--> Loudness-Optimierung am Audiowiedergabesystem 100), denn zum einen muß eine Frequenzgangmessung vom Benutzer aktivierbar sein (--> Bedienungsanleitung), und zum anderen kann die Optimierung durch Messen der Loudness-Kurven nach Frequenzgangmessungen in verschiedenen Audiosystemen nachgewiesen werden.

## Patentansprüche

1. Verfahren zur gehörrichtigen Anhebung des Basspegels (P) eines Wiedergabesystems (100) für Audiosignale mittels Einstellens mindestens eines Filterparameters mindestens einer dem Wiedergabesystem (100) zugeordneten Bassanhebungsfiltereinheit (26), wobei der mindestens eine Filterparameter der Bassanhebungsfiltereinheit (26) so eingestellt wird, dass die Anhebung des Basspegels (P) mit steigender Filfergrenzfrequenz (f_{c}) der *Bassanhebungsfiltereinheit* (26) bzw. mit steigender Mittenfrequenz (f₀) der Bassanhebungsfiltereinheit (26) derart reduziert wird, dass die Isophonen im verbleibenden wiedergebbaren Bassfrequenzbereich nicht überschritten werden,
**dadurch gekennzeichnet,**
**dass** der mindestens eine Filterparameter der Bassanhebungsfiltereinheit (26) automatisch so eingestellt wird, dass die Mittenfrequenz (f₀) der Bassanhebungsfiltereinheit (26) gerade oberhalb einer bestimmten Grenzfrequenz liegt, wobei
[a] zunächst der akustische Frequenzgang sowie der mittlere Schalldruck ermittelt werden und
[b] dann die Grenzfrequenz bestimmt wird, unterhalb derer der Schalldruck einen auf den mittleren Schalldruck bezogenen Schalldruckschwellwert unterschreitet, bevor
[c] der mindestens eine Filterparameter der Bassanhebungsfiltereinheit (26) eingestellt wird.

2. Verfahren gemäß Anspruch 1, **dadurch gekennzeichnet, dass** der akustische Frequenzgang ermittelt wird, indem
- mindestens eine Lautsprechereinrichtung (50) des Wiedergabesystems (100) nacheinander von Bandpass-Rauschsignalen mit unterschiedlichen Mittenfrequenzen (f₀) angesteuert wird, wobei die jeweils in Form mindestens eines Bandpass-Rauschsignals eingestellten Frequenzbänder das gesamte Audiospektrum abdecken, und
der Frequenzgang in Form von Frequenzmesspunkten für die einzelnen Frequenzbänder ermittelt wird, wobei als Frequenzmesspunkt für ein bestimmtes Frequenzband der Schallpegel des Signals bestimmt wird, das in diesem Fall von der Lautsprechereinrichtung (50) abgestrahlt wird.

3. Verfahren gemäß Anspruch 2, **dadurch gekennzeichnet, dass** die Bandpass-Rauschsignale zum Ermitteln des akustischen Frequenzgangs mittels mindestens eines dem Wiedergabesystem (100) zugeordneten digitalen Equalizers (22, 24), dem insbesondere die Bassanhebungsfiltereinheit (26) zugeordnet wird, erzeugt werden, indem
- dem Equalizer (22, 24) mindestens ein Rauschsignal zugeführt wird und
- der mindestens eine Filterparameter der Bassanhebungsfiltereinheit (26) so eingestellt wird, dass sich für den Equalizer (22, 24) eine Bandpasscharakteristik mit schmaler Bandbreite bei vorgegebener Mittenfrequenz (f₀) ergibt.

4. Verfahren gemäß mindestens einem der Ansprüche 1 bis 3, wobei der mindestens eine Filterparameter mittels mindestens zweier digitaler Equalizer (22, 24) automatisch eingestellt wird, **dadurch gekennzeichnet, dass** die Filterparameter der einzelnen Equalizer (22, 24) nacheinander bestimmt werden, indem jeweils vor der Bestimmung der Filterparameter eines Equalizers (22, 24) der bzw. die vorher eingestellten Equalizer (22, 24) auf den ermittelten Frequenzgang angewendet werden.

5. Wiedergabesystem (100) für Audiosignale, mittels dessen ein Verfahren gemäß mindestens einem der Ansprüche 1 bis 4 durch Einstellen mindestens eines Filterparameters mindestens einer mindestens einem digitalen Equalizer (22, 24) des Wiedergabesystems (100) zugeordneten Bassanhebungsfiltereinheit (26) durchführbar ist,
- mit mindestens einer Lautsprechereinrichtung (50) und
- mit mindestens einem den Equalizer (22, 24) aufweisenden Audioprozessor (20), der
-- im Signalpfad zwischen mindestens einer Signalquelle (10, 12) und der Lautsprechereinrichtung (50) angeordnet ist und
-- über mindestens einen Steuerungsbus (34) mit mindestens einem Steuerungsprozessor (30) verbunden ist,
**dadurch gekennzeichnet,**
- **dass** mindestens ein Rauschgeneratar- (40) vorgesehen ist, über den dem Equalizer (22, 24) mindestens ein Rauschsignal zuführbar ist,
- **dass** der Steuerungsprozessor (30) Mittel aufweist, über die der mindestens eine Filterparameter so eingestellt wird, dass der Equalizer (22, 24) eine Bandpasscharakteristik mit schmaler Bandbreite aufweist, wobei die Mittenfrequenz (f₀) über dem Audiospektrum variierbar ist,
- **dass** mindestens ein Mikrophon (60) mit Auswertemitteln (70) zum Erfassen des von der Lautsprechereinrichtung (50) abgestrahlten Signals und zum Bestimmen des Frequenzgangs vorgesehen ist und
- **dass** der Steuerungsprozessor (30) Mittel aufweist, mittels der der mindestens eine Filterparamete unter Berücksichtigung des gemessenen Frequenzgangs eingestellt wird, und die Grenzfrequenz bestimmt wird, unterhalb derer der Schalldruck einen auf den mittleren Schalldruck bezogenen Schalldruckschwellwert unterschreitet.

6. Wiedergabesystem gemäß Anspruch 5, **dadurch gekennzeichnet, dass** der Rauschgenerator (40)
- im Audioprozessor (20) implementiert und/oder
- in Form einer zusätzlichen externen Signalquelle realisiert ist.

7. Wiedergabesystem gemäß Anspruch 5 oder 6, **dadurch gekennzeichnet, dass** die Auswertemittel (70) zum Auswerten des vom Mikrophon (60) erfassten Signals Mittel zum Verstärken, zum Logarithmieren und zum Gleichrichten des Signals aufweisen.

8. Verwendung des Verfahrens gemäß mindestens einem der Ansprüche 1 bis 4 und/oder des Wiedergabesystems (100) gemäß mindestens einem der Ansprüche 5 bis 7 für Audiosignale in mindestens einem Fortbewegungsmittel, insbesondere im Innenraum mindestens eines Kraftfahrzeugs.

## Claims

1. Method for boosting the bass level (P) of a reproduction system (100) for audio signals in an aurally appropriate fashion by means of adjustment of at least one filter parameter of at least one bass boost filter unit (26) associated with the reproduction system (100), wherein the at least one filter parameter of the base boost filter unit (26) is adjusted such that the boost in the bass level (P) is reduced as the filter cut-off frequency (f_{c}) of the bass boost filter unit (26) rises or as the centre frequency (f₀) of the bass boost filter unit (26) rises such that the isophones in the remaining reproducible bass frequency range are not exceeded,
**characterized**
**in that** the at least one filter parameter of the bass boost filter unit (26) is automatically adjusted such that the centre frequency (f₀) of the bass boost filter unit (26) is just above a particular cutoff frequency, wherein
[a] first of all the acoustic frequency response and the average sound pressure are ascertained and
[b] then the cut-off frequency below which the sound pressure is below a sound pressure threshold value based on the average sound pressure is determined before
[c] the at least one filter parameter of the bass boost filter unit (26) is adjusted.

2. Method according to Claim 1, **characterized in that** the acoustic frequency response is ascertained by
- successively actuating at least one loudspeaker device (50) of the reproduction system (100) using bandpass noise signals with different centre frequencies (f₀), wherein the respective frequency bands adjusted in the form of at least one bandpass noise signal cover the entire audio spectrum, and
- ascertaining the frequency response in the form of frequency measurement points for the individual frequency bands, wherein a frequency measurement point determined for a particular frequency band is the sound level of the signal that is emitted by the loudspeaker device (50) in this case.

3. Method according to Claim 2, **characterized in that** the bandpass noise signals for ascertaining the acoustic frequency response are produced by means of at least one digital equalizer (22, 24) that is associated with the reproduction system (100), and to which particularly the bass boost filter unit (26) is assigned, by
- supplying at least one noise signal to the equalizer (22, 24) and
- adjusting the at least one filter parameter of the bass boost filter unit (26) such that a bandpass characteristic having a narrow bandwidth at a prescribed centre frequency (f₀) is obtained for the equalizer (22, 24).

4. Method according to at least one of Claims 1 to 3, wherein the at least one filter parameter is automatically adjusted by means of at least two digital equalizers (22, 24), **characterized in that** the filter parameters of the individual equalizers (22, 24) are determined successively by applying the previously adjusted equalizer(s) (22, 24) to the ascertained frequency response each time before the filter parameters of an equalizer (22, 24) are determined.

5. Reproduction system (100) for audio signals that is able to be used to carry out a method according to at least one of Claims 1 to 4 by adjusting at least one filter parameter of at least one bass boost filter unit (26) associated with at least one digital equalizer (22, 24) of the reproduction system (100),
- having at least one loudspeaker device (50) and
- having at least one audio processor (20) that has the equalizer (22, 24) and that
- is arranged in a signal path between at least one signal source (10, 12) and the loudspeaker device (50) and
- is connected to at least one control processor (30) by means of at least one control bus (34), **characterized**
- **in that** at least one noise generator (40) is provided that can be used to supply at least one noise signal to the equalizer (22, 24),
- **in that** the control processor (30) has means that are used to adjust the at least one filter parameter such that the equalizer (22, 24) has a bandpass characteristic having a narrow bandwidth, wherein the centre frequency (f₀) can be varied over the audio spectrum,
- **in that** at least one microphone (60) having evaluation means (70) for capturing the signal emitted by the loudspeaker device (50) and for determining the frequency response is provided, and
- **in that** the control processor (30) has means that are used to adjust the at least one filter parameter by taking into account the measured frequency response and to determine the cut-off frequency below which the sound pressure is below a sound pressure threshold value based on the average sound pressure.

6. Reproduction system according to Claim 5, **characterized in that** the noise generator (40)
- is implemented in the audio processor (20) and/or
- is provided in the form of an additional external signal source.

7. Reproduction system according to Claim 5 or 6, **characterized in that** the evaluation means (70) for evaluating the signal captured by the microphone (60) have means for amplifying, for logarithmizing and for rectifying the signal.

8. Use of the method according to at least one of Claims 1 to 4 and/or of the reproduction system (100) according to at least one of Claims 5 to 7 for audio signals in at least one means of transport, particularly in the interior of at least one motor vehicle.

## Revendications

1. Procédé pour renforcer de manière auditivement compensée le niveau des graves (P) d'un système de reproduction (100) pour des signaux audio par réglage d'au moins un paramètre de filtrage d'au moins une unité à filtre de renforcement des graves (26) associée au système de reproduction (100), dans lequel l'au moins un paramètre de filtrage de l'unité à filtre de renforcement des graves (26) est ajusté de manière à ce que le renforcement du niveau des graves (P) soit réduit lors d'une augmentation de la fréquence de coupure du filtre (f_{c}) de l'unité à filtre de renforcement des graves (26) ou lors d'une augmentation de la fréquence centrale (f₀) de l'unité à filtre de renforcement des graves (26) afin que les isophones ne soient pas dépassés dans la gamme des fréquences graves reproductibles restantes,
**caractérisé en ce que** l'au moins un paramètre de filtrage de l'unité à filtre de renforcement des graves (26) est ajusté automatiquement de manière à ce que la fréquence centrale (f₀) de l'unité à filtre de renforcement des graves (26) se situe juste au-dessus d'une fréquence de coupure donnée, dans lequel
[a] on détermine en premier lieu la réponse en fréquence acoustique et la pression sonore moyenne, et
[b] on détermine ensuite la fréquence de coupure en dessous de laquelle la pression sonore devient inférieure à un seuil de pression sonore par rapport à la pression sonore moyenne, avant que
[c] l'au moins un paramètre de filtrage de l'unité à filtre de renforcement des graves (26) soit ajusté.

2. Procédé selon la revendication 1, **caractérisé en ce que** la réponse en fréquence acoustique est déterminée en faisant en sorte que
- au moins un dispositif à haut-parleur (50) du système de reproduction (100) soit commandé séquentiellement par des signaux de bruit passe-bande ayant des fréquences centrales (f₀) différentes, les bandes de fréquences, qui sont chacune réglées sous la forme d'au moins un signal de bruit passe-bande, couvrant la totalité du spectre audio, et
- la réponse en fréquence est déterminée sous la forme de points de mesure de fréquence pour les bandes de fréquences individuelles, le niveau sonore du signal qui est émis dans ce cas par le dispositif à haut-parleur (50) étant déterminé en tant que point de mesure de fréquence pour une bande de fréquences donnée.

3. Procédé selon la revendication 2, **caractérisé en ce que** les signaux de bruit passe bande sont générés pour déterminer la réponse en fréquence acoustique au moyen d'au moins un égaliseur numérique (22, 24) associé au système de reproduction (100), qui est notamment associé à l'unité à filtre de renforcement des graves (26), en faisant en sorte que
- au moins un signal de bruit soit fourni à l'égaliseur (22, 24),
- l'au moins un paramètre de filtrage de l'unité à filtre de renforcement des graves (26) soit réglé de manière à obtenir pour l'égaliseur (22, 24) une caractéristique passe-bande présentant une plus faible largeur de bande à une fréquence centrale (f₀) prédéterminée.

4. Procédé selon au moins l'une des revendications 1 à 3, dans lequel l'au moins un paramètre de filtrage est automatiquement ajusté au moyen d'au moins deux égaliseurs numériques (22, 24), **caractérisé en ce que** les paramètres de filtrage des égaliseurs individuels (22, 24) sont déterminés séquentiellement en faisant en sorte qu'avant la détermination des paramètres de filtrage d'un égaliseur (22, 24), l'égaliseur ou les égaliseurs précédemment ajusté(s) (22, 24) soit ou soient respectivement appliqué(s) à la réponse en fréquence déterminée.

5. Système de reproduction (100) pour signaux audio au moyen duquel un procédé selon au moins l'une des revendications 1 à 4 peut être mis en oeuvre par ajustement d'au moins un paramètre de filtrage d'au moins une unité à filtre de renforcement des graves (26) associée à au moins un égaliseur numérique (22, 24) du système de reproduction (100),
- comprenant au moins un dispositif à hautparleur (50), et
- comprenant au moins un processeur audio (20) comportant l'égaliseur (22, 24), qui
- est disposé sur le trajet de signal entre au moins une source de signal (10, 12) et le dispositif à hautparleur (50), et
- est connecté à au moins un processeur de commande (30) par l'intermédiaire d'au moins un bus de commande (34),
**caractérisé**
- **en ce qu'**il est prévu au moins un générateur de bruit (40) par l'intermédiaire duquel au moins un signal de bruit peut être fourni à l'égaliseur (22, 24),
- **en ce que** le processeur de commande (30) comporte des moyens par l'intermédiaire desquels l'au moins un paramètre de filtrage est ajusté de manière à ce que l'égaliseur (22, 24) présente une caractéristique passe-bande ayant une plus faible largeur de bande, la fréquence centrale (f₀) pouvant être amenée à varier dans le spectre audio,
- **en ce qu'**il est prévu au moins un microphone (60) comportant des moyens d'évaluation (70) destinés à détecter le signal émis par le dispositif à haut-parleur (50) et à déterminer le réponse en fréquence, et
- **en ce que** le processeur de commande (30) comporte des moyens à l'aide desquels on ajuste l'au moins un paramètre de filtrage en tenant compte de la réponse en fréquence mesurée et à l'aide desquels on détermine la fréquence de coupure en dessous de laquelle la pression sonore devient inférieure à un seuil de pression sonore par rapport à la pression sonore moyenne.

6. Système de reproduction selon la revendication 5, **caractérisé en ce que** le générateur de bruit (40) est
- implanté dans le processeur audio (20) et/ou
- est réalisé sous la forme d'une source de signal externe supplémentaire.

7. Système de reproduction selon la revendication 5 ou 6, **caractérisé en ce que** les moyens d'évaluation (70) destinés à évaluer le signal détecté par le microphone (60) comportent des moyens destinés à amplifier, à convertir en valeur logarithmique et à redresser le signal.

8. Utilisation du procédé selon au moins l'une des revendications 1 à 4 et/ou du système de reproduction (100) selon au moins l'une des revendications 5 à 7 pour des signaux audio dans au moins un moyen de locomotion, notamment dans l'espace intérieur d'au moins un véhicule automobile.
